# EUROPEAN PATENT APPLICATION

(11) **EP 4 333 298 A1**
(43) Date of publication of application: **06.03.2024**
(21) Application number: 23193004.1
(22) Date of filing: 23.08.2023
(51) Int. Cl.: H03H 9/02, H03H 9/13

(54) **BAW RESONATOR WITH DUAL-STEP OXIDE BORDER RING STRUCTURE**

(30) Priority: 30.08.2022 US 202263402245 P; 18.07.2023 US 202318354249
(71) Applicant: Qorvo US, Inc., Greensboro, NC 27409 (US)
(72) Inventor: TAJIC, Alireza, Apopka, 32703 (US); BERER, Thomas, Apopka, 32703 (US); VERES, Istvan, Apopka, 32703 (US)
(74) Representative: D Young & Co LLP

(57) **Abstract**

The present disclosure relates to a bulk acoustic wave (BAW) resonator that includes a bottom electrode (66), a piezoelectric layer (58) over the bottom electrode (66), and a top electrode structure (60) with a top electrode (76) and a dual-step BO ring structure (52). Herein, the dual-step BO structure (52) is formed over the piezoelectric layer (58) and about a periphery of the top electrode structure, such that a central portion (82) of the piezoelectric layer (58) is not covered by the dual-step BO structure (52). The dual-step BO structure (52) is formed of an oxide material and includes an inner BO ring (86) with a first height (HIN) and an outer BO ring (88) with a second height (HOUT) that is larger than the first height, such that the dual-step BO structure (52) decreases in height toward the central portion (82) of the piezoelectric layer (58). The top electrode (76) is formed over the central portion (82) of the piezoelectric layer (58) and extends over the dual-step BO structure (52).
Transitions (92,90) from one step to the other in the multi-step frame (52) may be tapered. Top electrode (76) may be multilayered (94,98) with seed layers (96). Any of the layers above the frame may further have differing, varying thicknesses across the frame width. The frame may provide a lateral Bragg structure for suppressing energy leakage and undesired modes.

## Description

### Related Applications

This application claims the benefit of provisional patent application serial number 63/402,245, filed August 30, 2022, the disclosure of which is hereby incorporated herein by reference in its entirety.

### Field

The present disclosure relates to a bulk acoustic wave (BAW) resonator, and particularly but not exclusively to a BAW resonator with a dual-step oxide border ring structure.

### Background

Acoustic resonators and, particularly, bulk acoustic wave (BAW) resonators are used in many high-frequency, communication applications. In particular, BAW resonators are often employed in filter networks that operate at frequencies above 1.5 gigahertz (GHz) and require a flat passband, have exceptionally steep filter skirts and squared shoulders at the upper and lower ends of the passband, and provide excellent rejection outside of the passband. BAW-based filters also have relatively low insertion loss, tend to decrease in size as the frequency of operation increases, and are relatively stable over wide temperature ranges. As such, BAW-based filters are the filter of choice for many 3rd Generation (3G) and 4th Generation (4G) wireless devices, and are destined to dominate filter applications for 5th Generation (5G) wireless devices. Most of these wireless devices support cellular, wireless fidelity (Wi-Fi), Bluetooth, and/or near field communications on the same wireless device, and as such, pose extremely challenging filtering demands.

### Summary

Particular aspects are set out in the appended independent claims. Various optional embodiments are set out in the dependent claims.

Some implementations according to the present disclosure may address balancing increasing complexity of wireless devices with improving the performance of BAW resonators and BAW-based filters as well as decreasing the cost and size associated therewith.

The present disclosure relates to a bulk acoustic wave (BAW) resonator with a dual-step oxide border (BO) ring structure. The disclosed BAW resonator includes a bottom electrode, a piezoelectric layer over the bottom electrode, and a top electrode structure with a top electrode and the dual-step BO ring structure. Herein, the dual-step BO structure is formed over the piezoelectric layer and about a periphery of the top electrode structure, such that a central portion of the piezoelectric layer is not covered by the dual-step BO structure. The dual-step BO structure includes an inner BO ring with a first height and an outer BO ring with a second height that is larger than the first height, such that the dual-step BO structure decreases in height toward the central portion of the piezoelectric layer. The top electrode is formed over the central portion of the piezoelectric layer and extends over the dual-step BO structure.

In one embodiment of the BAW resonator, the dual-step BO structure is formed of a dielectric material.

In one embodiment of the BAW resonator, the dual-step BO structure is formed of silicon oxide.

In one embodiment of the BAW resonator, the first height of the inner BO ring is 40%-60% of the second height of the outer BO ring.

In one embodiment of the BAW resonator, the first height of the inner BO ring is between 100 nm and 500 nm, and the second height of the outer BO ring is between 200 nm and 1000 nm.

In one embodiment of the BAW resonator, the inner BO ring has a first width between 500 nm and 1.25 µm, and the outer BO ring has a second width between 1 µm and 2.25 µm.

In one embodiment of the BAW resonator, the dual-step BO structure further includes a first transition section laterally between the inner BO ring and the outer BO ring. Herein, a height of the first transition section varies from the first height of the inner BO ring to the second height of the outer BO ring to form a tapered wall.

In one embodiment of the BAW resonator, a first angle, which is formed between a tapered wall of the first transition section and a horizontal plane parallel with a top surface of the piezoelectric layer, is between 30 and 60 degrees.

In one embodiment of the BAW resonator, the dual-step BO structure further includes a second transition section formed about an inner periphery of the dual-step BO structure. Herein, a height of the second transition section varies from zero to the first height of the inner BO ring to form a tapered wall.

In one embodiment of the BAW resonator, a second angle, which is formed between a tapered wall of the second transition section and the horizontal plane is between 30 and 60 degrees.

In one embodiment of the BAW resonator, the first angle and the second angle have different angle values.

In one embodiment of the BAW resonator, the first angle and the second angle have a same angle value.

In one embodiment of the BAW resonator, the dual-step BO structure further includes a second transition section formed about an inner periphery of the dual-step BO structure. Herein, a height of the second transition section varies from zero to the first height of the inner BO ring to form a tapered wall.

In one embodiment of the BAW resonator, the top electrode structure further includes a BO extension and a top electrode lead. Herein, the BO extension is in contact with and extends outwardly from the outer BO ring of the dual-step BO structure. The top electrode lead is in contact with the top electrode and extends over the BO extension.

In one embodiment of the BAW resonator, the BO extension is formed of a same material as the dual-step BO structure.

In one embodiment of the BAW resonator, the dual-step BO structure is formed of silicon oxide.

In one embodiment of the BAW resonator, the top electrode includes a first top electrode layer, which is formed over the central region of the piezoelectric layer and extends over the dual-step BO structure, an electrode seed layer formed over the first top electrode layer, and a second top electrode layer formed over the electrode seed layer.

In one embodiment of the BAW resonator, the first top electrode layer is formed of tungsten (W), molybdenum (Mo), or platinum (Pt), the electrode seed layer is formed of Titanium Tungsten (TiW) or Titanium (Ti), and the second top electrode layer is formed of aluminum copper.

According to one embodiment, the BAW resonator further includes a passivation layer that covers the top electrode structure and portions of the piezoelectric layer exposed through the top electrode structure. Herein, the passivation layer is formed of Silicon Nitride (SiN), SiO2, or Silicon Oxynitride (SiON), with a thickness between 250 Å and 5000 Å.

In one embodiment of the BAW resonator, a certain portion of at least one of the first top electrode layer, the electrode seed layer, the second top electrode layer, and the passivation layer has a thickness change. Herein, the certain portion is above and confined within the inner BO ring.

In one embodiment of the BAW resonator, a certain portion of at least one of the first top electrode layer, the electrode seed layer, the second top electrode layer, and the passivation layer has a thickness change. Herein, the certain portion is above and confined within the outer BO ring.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
FIG. 1 is a diagram illustrating a conventional bulk acoustic wave (BAW) resonator.
FIG. 2 is a diagram graphically illustrating the magnitude and phase of the electrical impedance as a function of the frequency for a relatively ideal BAW resonator.
FIGs. 3A-3C are diagrams graphically illustrating phase curves for various conventional BAW resonators.
FIG. 4 is a diagram illustrating a conventional BAW resonator with a top electrode including a border (BO) ring.
FIG. 5 is a diagram graphically illustrating the relationship of the BO ring width to a quality factor at an antiresonance frequency (Qₚ) and the relative strength of BO modes formed.
FIG. 6 is a diagram graphically illustrating phase curves for BAW resonators with and without BO rings.
FIG. 7 is a cross-sectional diagram illustrating a BAW resonator where a BO region is arranged in a similar configuration to the BAW resonator of FIG. 4.
FIG. 8 is a cross-sectional diagram illustrating a typical BAW resonator where a BO region forms a dual-step configuration.
FIG. 9 is a cross-sectional diagram illustrating an example BAW resonator with a dual-step border ring structure according to embodiments of the present disclosure.
FIG. 10 is a cross-sectional diagram illustrating a portion of the BAW resonator with an extended dual-step border ring structure according to embodiments of the present disclosure.
FIGs. 11A -11C are diagrams graphically illustrating simulated 1-|S₁₁| responses for various configurations of BAW resonators.
FIGs. 12A -12C are diagrams graphically illustrating quality factor simulation results for various configurations of BAW resonators.

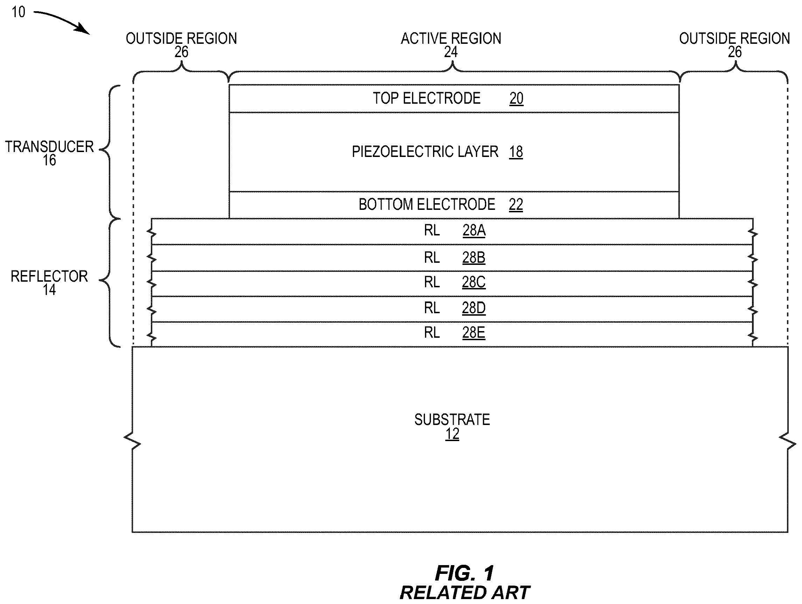

It will be understood that for clear illustrations, FIGs. 1-12C may not be drawn to scale.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

The present disclosure relates to a bulk acoustic wave (BAW) resonator, and particularly to a BAW resonator with a dual-step border (BO) ring structure. The disclosed BAW resonator is provided with a high quality factor, suppression of spurious modes, and suppression of BO modes.

Prior to delving into the details of these concepts, an overview of BAW resonators and filters that employ BAW resonators is provided. BAW resonators are used in many high-frequency filter applications. An example BAW resonator 10 is illustrated in FIG. 1. The BAW resonator 10 is a solidly mounted resonator (SMR) type BAW resonator and generally includes a substrate 12, a reflector 14 mounted over the substrate 12, and a transducer 16 mounted over the reflector 14. The transducer 16 rests on the reflector 14 and includes a piezoelectric layer 18, which is sandwiched between a top electrode 20 and a bottom electrode 22. The top and bottom electrodes 20, 22 may be formed of tungsten (W), molybdenum (Mo), platinum (Pt), or like material, and the piezoelectric layer 18 may be formed of aluminum nitride (AIN), zinc oxide (ZnO) or other appropriate piezoelectric material. Although shown in FIG. 1 as including a single layer, the piezoelectric layer 18, the top electrode 20, and/or the bottom electrode 22 may include multiple layers of the same material, multiple layers in which at least two layers are different materials, or multiple layers in which each layer is a different material.

The BAW resonator 10 is divided into an active region 24 and an outside region 26. The active region 24 generally corresponds to the section of the BAW resonator 10 where the top and bottom electrodes 20, 22 overlap and also includes the layers below the overlapping top and bottom electrodes 20, 22. The outside region 26 corresponds to the section of the BAW resonator 10 that surrounds the active region 24.

For the BAW resonator 10, applying electrical signals across the top electrode 20 and the bottom electrode 22 excites acoustic waves in the piezoelectric layer 18. These acoustic waves primarily propagate vertically. It may be appropriate in the BAW resonator design is to confine these vertically-propagating acoustic waves in the transducer 16. Acoustic waves traveling upwardly are reflected back into the transducer 16 by an air-metal boundary at a top surface of the top electrode 20. Acoustic waves traveling downwardly are reflected back into the transducer 16 by the reflector 14, or by an air cavity, which is provided just below the transducer 16 in a film bulk acoustic resonator (FBAR).

The reflector 14 is typically formed by a stack of reflector layers (RL) 28A through 28E (referred to generally as reflector layers 28), which alternate in material composition to produce a significant reflection coefficient at the junction of adjacent reflector layers 28. Typically, the reflector layers 28 alternate between materials having high and low acoustic impedances, such as tungsten (W) and silicon dioxide (SiO₂). While only five reflector layers 28 are illustrated in FIG. 1, the number of reflector layers 28 and the structure of the reflector 14 will vary from one design to another.

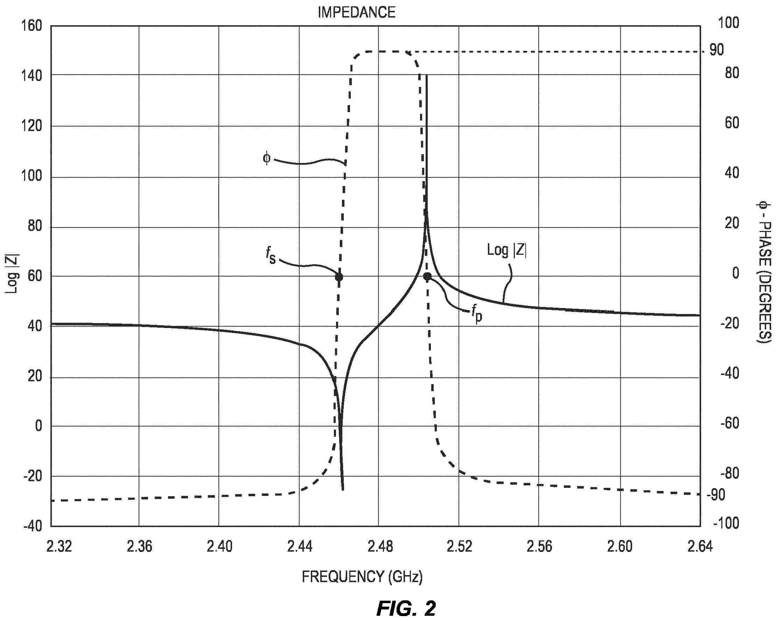

The magnitude (Z) and phase (φ) of the electrical impedance as a function of the frequency (GHz) for a relatively ideal BAW resonator 10 is provided in FIG. 2. The magnitude (Z) of the electrical impedance is illustrated by the solid line, while the phase (φ) of the electrical impedance is illustrated by the dashed line. A unique feature of the BAW resonator 10 is that it has both a resonance frequency and an antiresonance frequency. The resonance frequency is typically referred to as the series resonance frequency (*f*ₛ), and the antiresonance frequency is typically referred to as the parallel resonance frequency (*f*ₚ). The series resonance frequency (*f*ₛ) occurs when the magnitude of the impedance, or reactance, of the BAW resonator 10 approaches zero. The parallel resonance frequency (*f*ₚ) occurs when the magnitude of the impedance, or reactance, of the BAW resonator 10 peaks at a significantly high level. In general, the series resonance frequency (*f*ₛ) is a function of the thickness or height of the piezoelectric layer 18 and the mass of the top and bottom electrodes 20, 22.

For the phase, the BAW resonator 10 acts like an inductance that provides a 90° phase shift between the series resonance frequency (*f*ₛ) and the parallel resonance frequency (*f*ₚ). In contrast, the BAW resonator 10 acts like a capacitance that provides a -90° phase shift below the series resonance frequency (*f*ₛ) and above the parallel resonance frequency (*f*ₚ). The BAW resonator 10 presents a very low, near zero, resistance at the series resonance frequency (*f*ₛ), and a very high resistance at the parallel resonance frequency (*f*ₚ). The electrical nature of the BAW resonator 10 lends itself to the realization of a very high quality factor (Q) inductance over a relatively short range of frequencies, which has proven to be very beneficial in high frequency filter networks, especially those operating at frequencies around 1.8 GHz and above.

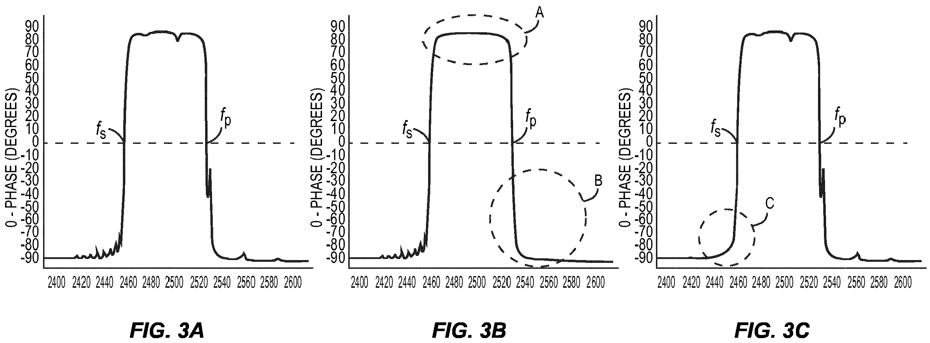

Unfortunately, the phase (φ) curve of FIG. 2 is representative of an ideal phase curve. In reality, approaching this ideal is challenging. A typical phase curve for the BAW resonator 10 of FIG. 1 is illustrated in FIG. 3A. Instead of being a smooth curve, the phase curve of FIG. 3A includes a ripple below the series resonance frequency (*f*ₛ), between the series resonance frequency (*f*ₛ) and the parallel resonance frequency (*f*ₚ), and above the parallel resonance frequency (*f*ₚ). The ripple is the result of spurious modes, which are caused by spurious resonances that occur in corresponding frequencies. While the vast majority of the acoustic waves in the BAW resonator 10 propagate vertically, various boundary conditions about the transducer 16 result in the propagation of lateral (horizontal) acoustic waves, which are referred to as lateral standing waves. The presence of these lateral standing waves reduces the potential quality factor (Q) associated with the BAW resonator 10.

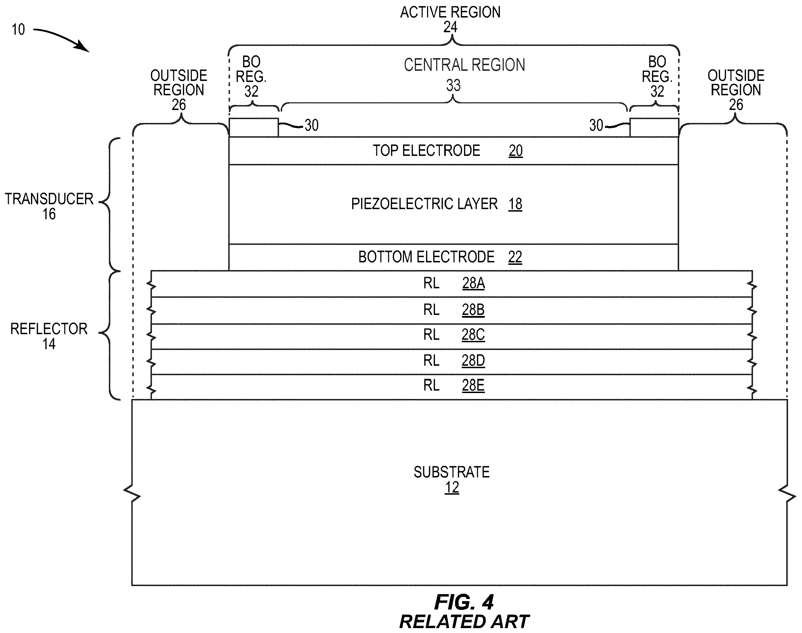

As illustrated in FIG. 4, a BO ring 30 is formed on or within (not shown) the top electrode 20 to suppress certain ones of the spurious modes. The spurious modes that are suppressed by the BO ring 30 are those above the series resonance frequency (*f*ₛ), as highlighted by circles A and B in the phase curve of FIG. 3B. Circle A shows a suppression of the ripple, and thus the spurious mode, in the passband of the phase curve, which resides between the series resonance frequency (*f*ₛ) and the parallel resonance frequency (*f*ₚ). Circle B shows suppression of the ripple, and thus the spurious modes, above the parallel resonance frequency (*f*ₚ). Notably, the spurious mode in the upper shoulder of the passband, which is just below the parallel resonance frequency (*f*ₚ), and the spurious modes above the passband are suppressed, as evidenced by the smooth or substantially ripple free phase curve between the series resonance frequency (*f*ₛ) and the parallel resonance frequency (*f*ₚ) and above the parallel resonance frequency (*f*ₚ).

The BO ring 30 corresponds to a mass loading of a portion of the top electrode 20 that extends about a periphery of the active region 24. In this regard, the BO ring 30 with mass loading forms a raised frame that is arranged about a periphery of the top electrode 20. The BO ring 30 may correspond to a thickened portion of the top electrode 20 or the application of additional layers of an appropriate material over the top electrode 20. The portion of the BAW resonator 10 that includes and resides below the BO ring 30 is referred to as a BO region 32. Accordingly, the BO region 32 corresponds to an outer, perimeter portion of the active region 24 and resides inside the active region 24. In addition, a central region 33 of the BAW resonator 10 is defined laterally inside of the BO region 32 and is not covered by the BO ring 30.

While the BO ring 30 is effective at suppressing spurious modes above the series resonance frequency (*f*ₛ), the BO ring 30 has little or no impact on those spurious modes below the series resonance frequency (*f*ₛ), as shown in FIG. 3B. A technique referred to as apodization is often used to suppress the spurious modes that fall below the series resonance frequency (*f*ₛ).

Apodization works to avoid, or at least significantly reduce, any lateral symmetry in the BAW resonator 10, or at least in the transducer 16 thereof. The lateral symmetry corresponds to the footprint of the transducer 16, and avoiding the lateral symmetry corresponds to avoiding symmetry associated with the sides of the footprint. For example, one may choose a footprint that corresponds to a pentagon instead of a square or rectangle. Avoiding symmetry helps reduce the presence of lateral standing waves in the transducer 16. Circle C of FIG. 3C illustrates the effect of apodization in which the spurious modes below the series resonance frequency (*f*ₛ) are suppressed. Assuming that no BO ring 30 is provided, one can readily see in FIG. 3C that apodization fails to suppress those spurious modes above the series resonance frequency (*f*ₛ). As such, the typical BAW resonator 10 employs both apodization and the BO ring 30.

A thickness or height of the BO ring 30 may be measured in a direction perpendicular to or away from a top surface of the piezoelectric layer 18 and a width of the BO ring 30 may be measured in a direction parallel to or laterally across the piezoelectric layer 18. The thickness and the width of the BO ring 30 may be concurrently tuned to provide suppression of spurious modes and to provide improvements to the quality factor at an antiresonance frequency (Oₚ). The added mass associated with the BO ring 30 typically causes the BO region 32 to resonate at a slightly lower frequency than other portions of the active region 24. As a result, the presence of BO rings can introduce undesirable modes, or BO modes, at frequencies below the series resonance frequency (*f*ₛ).

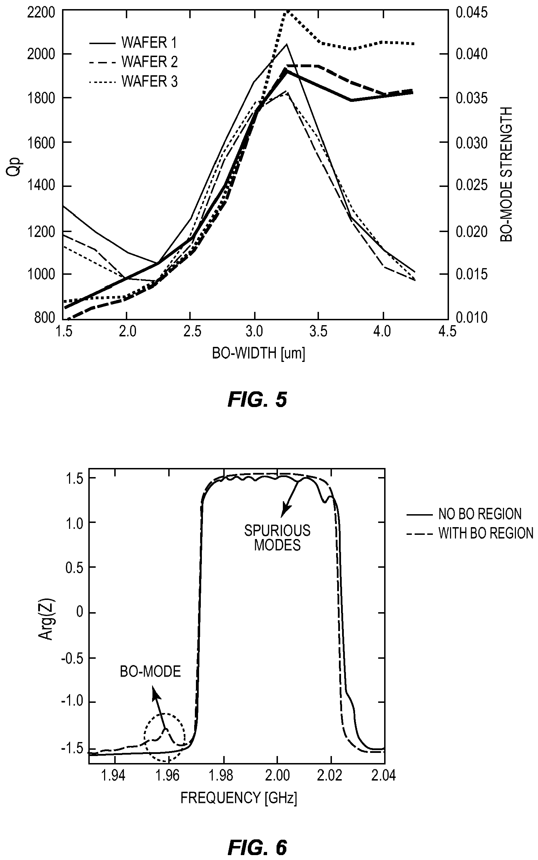

FIG. 5 is a diagram graphically illustrating the relationship of the BO ring width to the quality factor at the antiresonance frequency (Qₚ) and the relative strength of BO modes formed. In FIG. 5, the x-axis represents the BO ring width in microns (µm) while the primary y-axis represents the Qₚ and the secondary y-axis represents a relative strength or magnitude of the BO modes formed. The diagram of FIG. 5 plots data for three wafers that each include BAW resonators with varying BO ring widths. As shown, the Qₚ values generally increase with increasing BO ring widths and a highest Qₚ value corresponds to a BO ring width of just over 3 µm. As also shown, the BO mode strength also generally increases with increasing BO ring widths. For even higher BO ring widths, the Qₚ values decrease while the BO mode strength values remain high. In this manner, a BO ring that is tuned to provide a high Qₚ may also introduce undesirable BO modes to the corresponding BAW device.

FIG. 6 is a diagram graphically illustrating the phase curves for BAW resonators with and without BO rings. As illustrated, spurious modes that are present within the passband of a BAW resonator without a BO ring are suppressed with the addition of a BO ring; however, the presence of the BO ring introduces undesirable BO modes below the passband. BO modes may be introduced outside or even inside the passband of the resonator and may restrict the design or use of BAW resonators for wide bandwidth filtering applications. If the BO modes are within the passband, insertion loss can be impacted. BO modes that are present outside of the passband can be problematic for BAW multiplexing applications where BAW filters of different frequency bands operate at the same time. In such multiplexing applications, BO modes of one BAW filter can fall into the passband of other BAW filters and introduce interference during multiplexing.

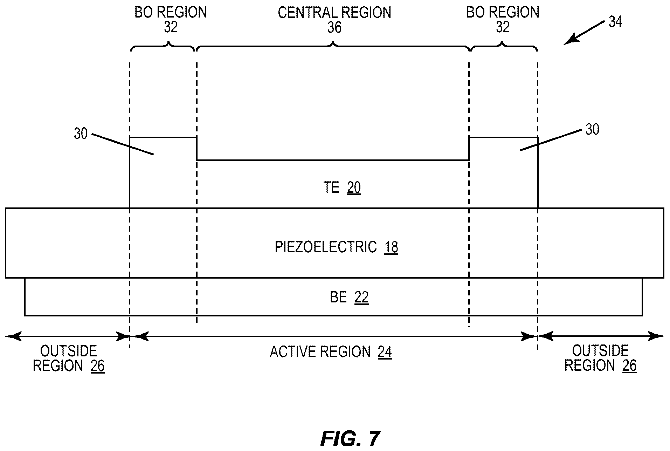

FIG. 7 is a cross-sectional diagram illustrating a BAW resonator 34 where the BO region 32 is arranged in a similar configuration to the BAW resonator 10 of FIG. 4. For illustrative purposes, FIG. 7 is a simplified view of the BAW resonator 34 and is not necessarily drawn to scale; however, it is understood that the BAW resonator 34 may include many of the same components as the BAW resonator 10 of FIG. 4. As illustrated in FIG. 7, the BO region 32 is arranged about a periphery of the top electrode 20 and a central region 36 of the top electrode 20 is defined laterally inside of the BO region 32. The BO ring 30 is formed on or within the top electrode 20 to suppress certain ones of the spurious modes as described above for FIG. 4. In FIG. 7, the active region 24 is indicated as the section where the top electrode 20 and the bottom electrode 22 overlap on opposing sides of the piezoelectric layer 18. In this manner, the active region 24 generally corresponds to a portion of the piezoelectric layer 18 that is electrically driven such that an electric field is provided between overlapping portions of the top electrode 20 and the bottom electrode 22. The outside region 26 generally corresponds to the portion of the piezoelectric layer 18 that is outside of the active region 24 and in this regard, the outside region 26 is generally not electrically driven. In the configuration of FIG. 7, the BO region 32 and the corresponding BO ring 30 are arranged within the active region 24.

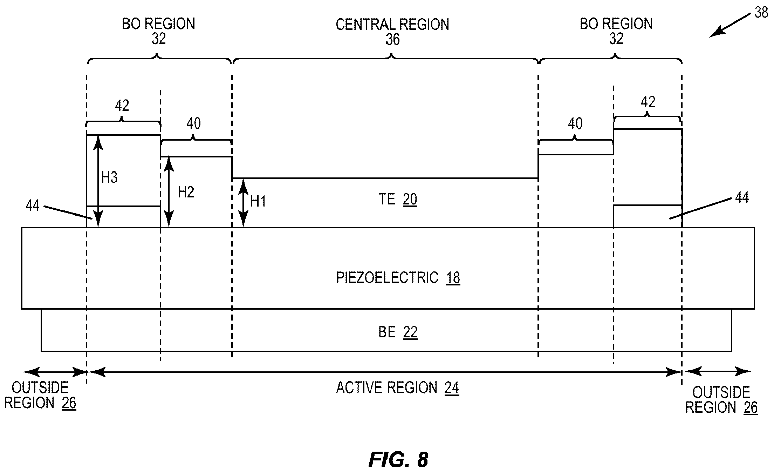

FIG. 8 is a cross-sectional diagram illustrating a BAW resonator 38 with a typical dual-step BO configuration about a periphery of the top electrode 20. For illustrative purposes, FIG. 8 is a simplified view of the BAW resonator 38 and is not necessarily drawn to scale; however, it is understood that the BAW resonator 38 may include many of the same components as the BAW resonator 10 of FIG. 4. The BO region 32 includes an inner step 40 and an outer step 42 that collectively form a stepped profile of raised heights that decrease from a periphery of the BO region 32 toward the central region 36 of the top electrode 20. The inner step 40 is a first mass loading portion of the top electrode 20 and the outer step 42 is a second mass loading portion of the top electrode 20. As indicated in FIG. 8, the central region 36 of the top electrode 20 has a first height H1 as measured from the piezoelectric layer 18, the inner step 40 of the top electrode 20 has a second height H2 as measured from the piezoelectric layer 18, and the outer step 42 of the top electrode 20 has a third height H3 as measured from the piezoelectric layer 18. The third height H3 is greater than the second height H2, and the second height H2 is greater than the first height H1, thereby forming a dual-step configuration for the BO region 32 that decreases in height toward the central region 36.

The top electrode 20 may include a number of conductive electrode layers (not shown). The inner step 40 is formed due to a thickness increment (i.e., thickness increment about H2-H1) of one or more of the conductive electrode layers in the BO region 32 compared to the central region 36. The outer step 42 is formed due to a dielectric ring layer 44 and the thickness increment of the one or more of the conductive electrode layers in the BO region 32. Herein, the dielectric ring layer 44 is located vertically between the top electrode 20 and the piezoelectric layer 18, and peripheral edges of the dielectric ring layer 44 are aligned with peripheral edges of the top electrode 20. Typically, the second height H2 is greater than the first height H1 in a range from 40 nanometers (nm) to 80 nm, and the third height H3 is greater than the second height H2 in a range from 80 nm to 180 nm.

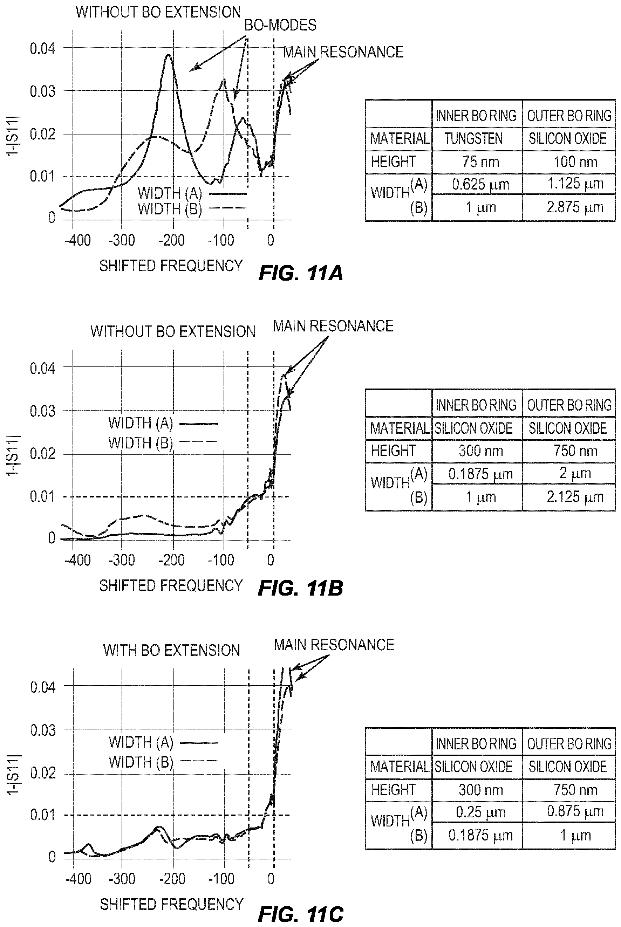

By having a dual-step configuration where the inner step 40 and the outer step 42 are arranged with different heights, the BO region 32 is thereby configured to provide two different acoustic impedances. This provides acoustic impedance mismatch for laterally propagating Lamb waves within the BAW resonator 38 that would otherwise contribute to loss of energy or energy leakage and the reduction of the Q factor for the BAW resonator 38. In this manner, the dual-step configuration in the BAW resonator 38 significantly reduces lateral energy leakage, thereby providing a high Q-value for the BAW resonator 38. In addition, the dielectric nature of the dielectric ring layer 44 serves to reduce some electric fields in the piezoelectric layer 18 and will reduce coupling in that domain, thereby suppressing magnitude of the BO modes formed. However, for some applications, such as multiplexing applications, the BO mode suppression in the BAW resonator 38 might not be enough (more details shown in FIGs. 11A-11C). Greater BO mode suppression without sacrificing Q-value of a BAW resonator is highly desired.

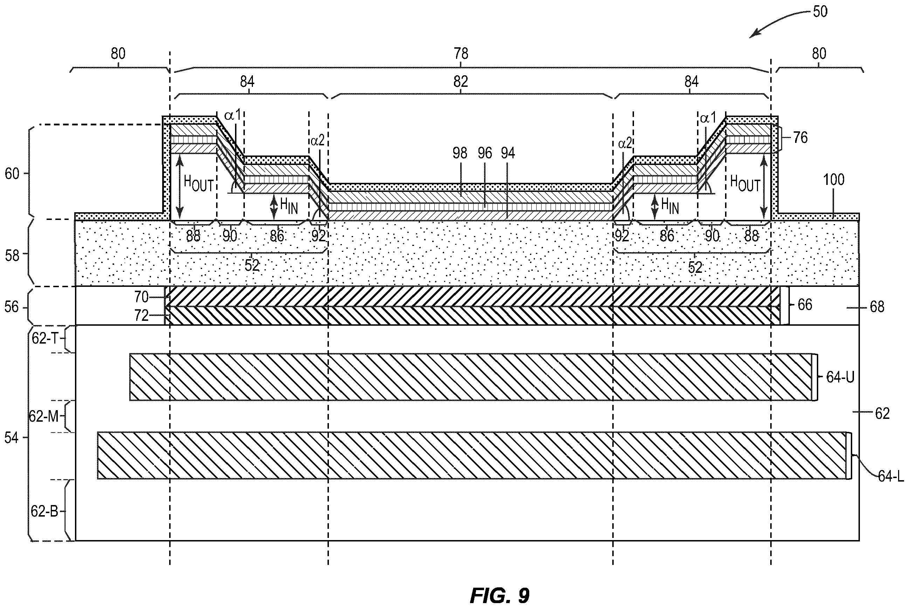

FIG. 9 is a cross-sectional diagram illustrating an example BAW resonator 50 with a dual-step BO structure 52 according to embodiments of the present disclosure. For the purpose of this illustration, the BAW resonator 50 is a BAW solidly mounted resonator (SMR) and includes a reflector 54, a bottom electrode structure 56 over the reflector 54, a piezoelectric layer 58 over the bottom electrode structure 56, and a top electrode structure 60 over the piezoelectric layer 58. In different applications, the BAW resonator 50 may be a film bulk acoustic resonator (FBAR), in which the reflector 54 is omitted.

In detail, the reflector 54 includes a low acoustic impedance region 62, and multiple high acoustic impedance layers 64 are embedded within the low acoustic impedance region 62. For the purpose of this illustration, there are two high acoustic impedance layers 64: an upper high acoustic impedance layer 64-U, and a lower high acoustic impedance section 64-L. In different applications, there may be fewer or more high acoustic impedance layers 64 embedded in the low acoustic impedance region 62. Herein, the lower high acoustic impedance layer 64-L resides over a bottom portion 62-B of the low acoustic impedance region 62. The upper high acoustic impedance layer 64-U is vertically above the lower high acoustic impedance layer 64-L and is separate from the lower high acoustic impedance layer 64-L by a middle portion 62-M of the low acoustic impedance region 62. A top portion 62-T of the low acoustic impedance region 62 is over the upper high acoustic impedance layer 64-U. The low acoustic impedance region 62 has lower acoustic impedance, lower density, and lower stiffness than the high acoustic impedance layers 64 and may be formed of SiO₂. Each high acoustic impedance layer 64 is formed of a high acoustic impedance material, such as W, Mo, or Pt. Each of the bottom portion 62-B of the low acoustic impedance region 62, the lower high acoustic impedance layer 64-L, the middle portion 62-M of the low acoustic impedance region 62, the upper high acoustic impedance layer 64-U, and the top portion 62-T of the low acoustic impedance region 62 is one RL of the reflector 54.

The bottom electrode structure 56 is formed over the top portion 62-T of the low acoustic impedance region 62 and includes a bottom electrode 66 and a planarization oxide 68. The bottom electrode 66 is vertically above the high acoustic impedance layers 64. The planarization oxide 68 surrounds the bottom electrode 66 and is capable of electrically separating the bottom electrode 66 with external bottom electrodes (not shown). The bottom electrode 66 may include two bottom electrode layers 70 and 72. The second bottom electrode layer 72 is over the top portion 62-T of the low acoustic impedance region 62 and may be formed of aluminum copper (AlCu), while the first bottom electrode layer 70 is over the second bottom electrode layer 72 and may be formed of W, Mo, or Pt. The planarization oxide 68 may be formed of SiO₂.

The piezoelectric layer 58 is formed over the bottom electrode structure 56 and at least fully covers the bottom electrode 66. The piezoelectric layer 58 may be formed of AlN, ZnO or other appropriate piezoelectric materials, and may have a thickness between 0.3 µm and 1.4 µm.

The top electrode structure 60 is formed over the piezoelectric layer 58 and is vertically above the bottom electrode 66. The top electrode structure 60 includes the dual-step BO structure 52, which is formed over the piezoelectric layer 58 and about a periphery of the top electrode structure 60, and a top electrode 76, which is formed over the piezoelectric layer 58 and extends over the dual-step BO structure 52. Peripheral edges of the dual-step BO structure 52 may be aligned with peripheral edges of the top electrode 76.

The BAW resonator 50 is divided into an active region 78 and an outside region 80. The active region 78 corresponds to a section of the BAW resonator 50 where the top and bottom electrodes 76, 66 overlap and also includes the layers in-between and below the overlapping top and bottom electrodes 76, 66. The outside region 80 corresponds to the section of the BAW resonator 50 that surrounds the active region 78. The active region 78 is divided into a central region 82 and a BO region 84. The BO region 84 corresponds to a section of the BAW resonator 50 that includes, resides over, and resides below the dual-step BO structure 52. The central region 82 is defined laterally inside of the BO region 84 and is not covered by the dual-step BO structure 52.

Notably, the bottom electrode 66 may extend beyond the peripheral edges of the top electrode 76. As previously described, the active region 78 is formed where the top and bottom electrodes 76, 66 overlap. In this manner, misalignment of the top electrode 76 with the bottom electrode 66 during fabrication may impair performance of the BAW resonator 50. By arranging the bottom electrode 66 with larger lateral dimensions than the top electrode 76, alignment tolerances for placement of the top electrode 76 may be increased, thereby improving manufacturing tolerances.

The dual-step BO structure 52 includes an inner BO ring 86 with an inner ring height H_{IN} and an outer BO ring 88 with an outer ring height H_{OUT}. Herein, the outer ring height H_{OUT} is larger than the inner ring height H_{IN}, such that the dual-step BO structure 52 decreases in height toward the central region 82. In one embodiment, the top electrode 76 has a uniform thickness, and mass loading portions of the top electrode structure 60 have a dual-step configuration and come from the dual-step BO structure 52.

By having a dual-step configuration, the mass loading portions of the top electrode structure 60 within the BO region 84 are thereby configured to provide two different acoustic impedances. This provides acoustic impedance mismatch for laterally propagating Lamb waves within the BAW resonator 50 that would otherwise contribute to loss of energy or energy leakage and the reduction of the Q factor for the BAW resonator 50. To achieve a desirably large acoustic mismatch and a corresponding large reflection coefficient, a material of large mass density is desired for the inner BO ring 86 and the outer ring 88. In addition, to superiorly suppress BO modes, a material, which can reduce some electric fields in a portion of the piezoelectric layer 58 within the BO region 84 (compared to the electrical field of another portion of the piezoelectric layer 58 within the central region 82) and thereby reduce coupling in that domain, is highly desired. As such, the entire dual-step BO structure 52 is formed of a dielectric material, such as SiO₂.

Furthermore, the inner ring height H_{IN} of the inner BO ring 86 and the outer ring height H_{OUT} of the outer BO ring 88 will significantly affect the suppression of BO modes and thus a careful choice of this height may be appropriate. In one embodiment, the inner ring height H_{IN} of the inner BO ring 86 is 40%-60% of the outer ring height H_{OUT} of the outer BO ring 88. The inner ring height H_{IN} of the inner BO ring 86 is between 100 nm and 500 nm, while the outer ring height H_{OUT} of the outer BO ring 88 is between 200 nm and 1000 nm. Besides the inner and outer ring heights H_{IN} and H_{OUT}, widths of the inner BO ring 86 and the outer BO ring 88 may also be concurrently tuned to improve lateral energy confinement and quality factor. In one embodiment, a width of the inner BO ring 86 is between 500 nm and 1.25 µm, while a width of the outer BO ring 88 is between 1 µm and 2.25 µm.

To achieve the height variation between the inner BO ring 86 and the outer BO ring 88, the dual-step BO structure 52 further includes a first transition section 90 laterally between the inner BO ring 86 and the outer BO ring 88. A height of the first transition section 90 varies from the inner ring height H_{IN} to the outer ring height H_{OUT} to form a tapered wall. A first angle α1 formed between the tapered wall of the first transition section 90 and a horizontal plane (e.g., parallel with a top surface of the piezoelectric layer 58) is between 30 and 60 degrees. In addition, the dual-step BO structure 52 also includes a second transition section 92 formed about an inner periphery of the BO region 84, and laterally between the central region 82 and the inner BO ring 86. A height of the second transition section 92 varies from zero to the inner ring height to form a tapered wall. A second angle α2 formed between the tapered wall of the second transition section 92 and the horizontal plane (e.g., parallel with the top surface of the piezoelectric layer 58) is between 30 and 60 degrees. The first angle α1 and the second angle α2 may be different or the same.

The top electrode 76 includes a first top electrode layer 94 formed over the piezoelectric layer 58 within the central region 82 and extending over the dual-step BO structure 52, an electrode seed layer 96 formed over the first top electrode layer 94, and a second top electrode layer 98 formed over the electrode seed layer 96. Herein, the first top electrode layer 94 may be formed of W, Mo, Pt, or other electrically conductive materials with high acoustic impedance properties. The electrode seed layer 96 may be formed of Titanium Tungsten (TiW) or Titanium (Ti). The second top electrode layer 98 may be formed of AlCu or other highly electrically conductive materials.

Furthermore, the BAW resonator 50 may also include a passivation layer 100 to protect the example BAW resonator 50 from an external environment. The passivation layer 100 covers the top electrode structure 60 and portions of the piezoelectric layer 58 that are exposed through the top electrode structure 60. The passivation layer 100 may be formed of Silicon Nitride (SiN), SiO₂, or Silicon Oxynitride (SiON), with a thickness between 250 Å and 5000 Å.

In one embodiment, each of the first top electrode layer 94, the electrode seed layer 96, the second top electrode layer 98, and the passivation layer 100 has a uniform thickness, and the mass loading portions of the top electrode structure 60 come from the dual-step BO structure 52. In one embodiment, a portion of at least one layer (e.g., a portion of the first top electrode layer 94, a portion of the electrode seed layer 96, a portion of the second top electrode layer 98, and/or a portion of the passivation layer 100) above and confined within the inner BO ring 86 has a thickness change (thickness increment or thickness decrement). In one embodiment, a portion of at least one layer (e.g., a portion of the first top electrode layer 94, a portion of the electrode seed layer 96, a portion of the second top electrode layer 98, and/or a portion of the passivation layer 100) above and confined within the outer BO ring 88 has a thickness change (thickness increment or thickness decrement). As such, the mass loading portions of the top electrode structure 60 may come from the dual-step BO structure 52, the thickness variation(s) of the top electrode 76/the passivation layer 100 confined in the inner BO ring 86 and/or the outer BO ring 88 (not shown).

Notice that regardless of the presence of the reflector 54 (i.e., regardless of the SMR and FBAR applications), the BAW resonator 50 always includes the bottom electrode structure 56, the piezoelectric layer 58 over the bottom electrode structure 56, and the top electrode structure 60 with the oxide dual-step BO structure 52 over the piezoelectric layer 58. The oxide material and the dual-step configuration of the dual-step BO structure 52 improves the Q factor for the BAW resonator 50 and significantly suppresses the BO modes of the BAW resonator 50 (see FIGs 11A-12C for more details).

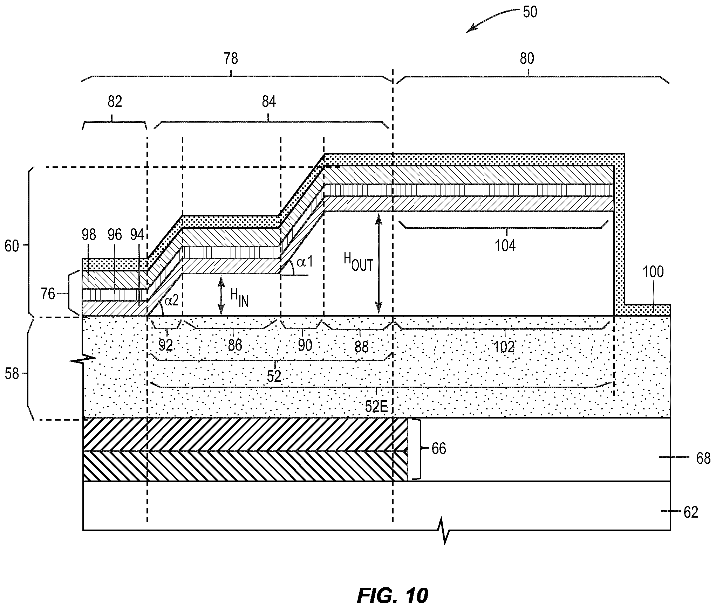

In different applications, the top electrode structure 60 may further include a BO extension 102, which is connected to the dual-step BO structure 52, and a top electrode lead 104, which is connected to the top electrode 76, as illustrated in FIG. 10. Herein, the BO extension 102 is in contact with and extends outwardly from the outer BO ring 88 of the dual-step BO structure 52. The BO extension 102 may be formed of a same oxide material (e.g., SiO₂) as the dual-step BO structure 52. A combination of the dual-step BO structure 52 and the BO extension 102 forms an extended BO structure 52E. The BO extension 102 has a same height as the outer BO ring 88 of the dual-step BO structure 52, such that the extended BO structure 52E also has a dual-step configuration.

The top electrode lead 104 extends outwardly from the top electrode 76 and extends over the BO extension 102. The top electrode 76 and the top electrode lead 102 are formed from the common first top electrode layer 94, the common electrode seed layer 96, and the common second top electrode layer 98. The BO extension 102 and the top electrode lead 104 reside within the outside regions 80.

FIGs. 11A -11C illustrate simulation results of 1-|S₁₁| responses for various configurations of BAW resonators as illustrated in FIGs 8-10 (1-|S₁₁| is equal to the power ratio lost in a resonator). FIG. 11A shows 1-|S₁₁| responses of two simulated BAW resonators with the same configuration shown in FIG. 8. Each of these two simulated BAW resonators has a dual-step configuration that includes a tungsten inner BO ring with a 75 nm height and a SiO₂ outer BO ring with a 100 nm height, and includes no BO extension. For one of these two simulated BAW resonators, the tungsten inner BO ring has a 0.625 µm width and the SiO₂ outer BO ring has a 1.125 µm width, while for the other one of these two simulated BAW resonators, the tungsten inner BO ring has a 1 µm width and the SiO₂ outer BO ring has a 2.875 µm width.

FIG. 11B shows 1-|S₁₁| responses of two simulated BAW resonators with the same configuration shown in FIG. 9. Each of these two simulated BAW resonators has a dual-step configuration that includes a SiO₂ inner BO ring with a 300 nm height and a SiO₂ outer BO ring with a 750 nm height, and includes no BO extension. For one of these two simulated BAW resonators, the SiO₂ inner BO ring has a 0.1875 µm width and the SiO₂ outer BO ring has a 2 µm width, while for the other one of these two simulated BAW resonators, the SiO₂ inner BO ring has a 1 µm width and the SiO₂ outer BO ring has a 2.125 µm width.

FIG. 11C shows 1-|S₁₁| responses of two simulated BAW resonators with the same configuration shown in FIG. 10. Each of these two simulated BAW resonators has a dual-step configuration that includes a SiO₂ inner BO ring with a 300 nm height and a SiO₂ outer BO ring with a 750 nm height, and also includes a BO extension. For one of these two simulated BAW resonators, the SiO₂ inner BO ring has a 0.25 µm width and the SiO₂ outer BO ring has a 0.875 µm width, while for the other one of these two simulated BAW resonators, the SiO₂ inner BO ring has a 0.1875 µm width and the SiO₂ outer BO ring has a 1 µm width.

It is clear that, regardless of the presence of the BO extension, when the inner BO ring and outer BO ring are both formed of SiO₂ and have large heights (e.g., 300 nm and 750 nm, respectively), the BO modes are significantly suppressed (FIG. 11B and 11C). On the other hand, when the inner BO ring is formed of W and the inner BO ring and outer BO ring have relatively small heights (e.g., 75 nm and 100 nm, respectively), the BO modes are comparable to the main resonance (FIG. 11A).

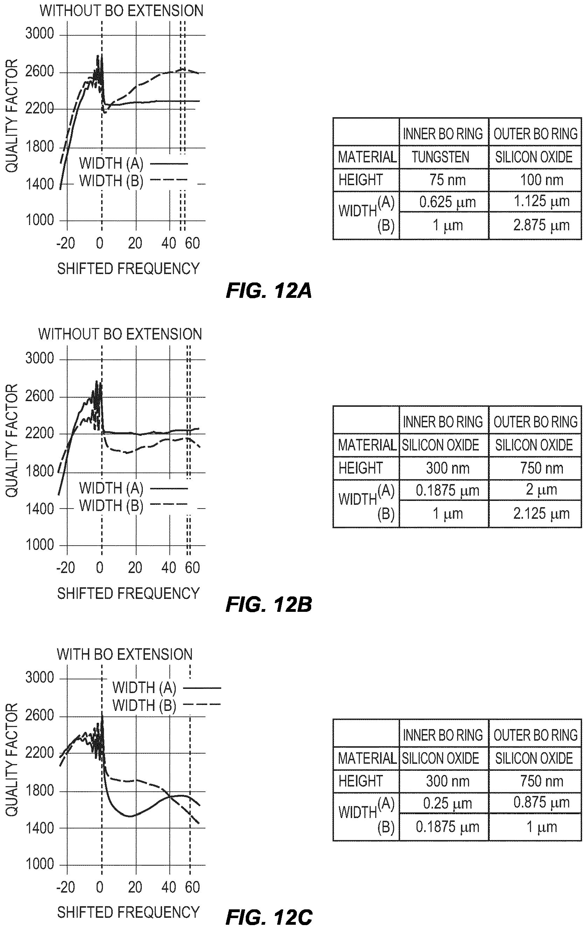

FIGs. 12A -12C illustrate quality factor simulation results for various configurations of BAW resonators. FIG. 12A shows quality factor simulation results of the two simulated BAW resonators utilized in FIG. 11A, FIG. 12B shows quality factor simulation results of the two simulated BAW resonators utilized in FIG. 11B, and FIG. 12C shows quality factor simulation results of the two simulated BAW resonators utilized in FIG. 11C.

In the absence of the BO extension, the BAW resonators with thick SiO₂ inner and outer BO rings and the BAW resonators with a relatively thin W inner BO ring and a relatively thin SiO₂ outer BO ring may achieve similar high-value quality factors. On the other hand, the quality factors for the BAW resonators, which have the thick SiO₂ inner and outer BO rings and the BO extension, have reduced but still acceptable values.

Thus, from one perspective, there has now been described a bulk acoustic wave (BAW) resonator that includes a bottom electrode, a piezoelectric layer over the bottom electrode, and a top electrode structure with a top electrode and the dual-step BO ring structure. The dual-step BO structure is formed over the piezoelectric layer and about a periphery of the top electrode structure, such that a central portion of the piezoelectric layer is not covered by the dual-step BO structure. The dual-step BO structure is formed of an oxide material and includes an inner BO ring with a first height and an outer BO ring with a second height that is larger than the first height, such that the dual-step BO structure decreases in height toward the central portion of the piezoelectric layer. The top electrode is formed over the central portion of the piezoelectric layer and extends over the dual-step BO structure.

Further examples are set out in the following numbered clauses.

Clause 1. A bulk acoustic wave (BAW) resonator comprising: a bottom electrode; a piezoelectric layer over the bottom electrode; and a top electrode structure including a top electrode and a dual-step border (BO) ring structure, wherein: the dual-step BO structure is formed over the piezoelectric layer and about a periphery of the top electrode structure, such that a central portion of the piezoelectric layer is not covered by the dual-step BO structure; the dual-step BO structure includes an inner BO ring with a first height and an outer BO ring with a second height that is greater than the first height, such that the dual-step BO structure decreases in height toward the central portion of the piezoelectric layer; and the top electrode is formed over the central portion of the piezoelectric layer and extends over the dual-step BO structure.

Clause 2. The BAW resonator of clause 1, wherein the dual-step BO structure is formed of a dielectric material.

Clause 3. The BAW resonator of clause 2, wherein the dual-step BO structure is formed of silicon oxide.

Clause 4. The BAW resonator of clause 1, 2 or 3, wherein the first height of the inner BO ring is 40%-60% of the second height of the outer BO ring.

Clause 5. The BAW resonator of any preceding clause, wherein the first height of the inner BO ring is between 100 nm and 500 nm, and the second height of the outer BO ring is between 200 nm and 1000 nm.

Clause 6. The BAW resonator of any preceding clause, wherein the inner BO ring has a first width between 500 nm and 1.25 µm, and the outer BO ring has a second width between 1 µm and 2.25 µm.

Clause 7. The BAW resonator of any preceding clause, wherein the dual-step BO structure further includes a first transition section laterally between the inner BO ring and the outer BO ring, wherein a height of the first transition section varies from the first height of the inner BO ring to the second height of the outer BO ring to form a tapered wall.

Clause 8. The BAW resonator of clause 7, wherein a first angle, which is formed between a tapered wall of the first transition section and a horizontal plane parallel with a top surface of the piezoelectric layer, is between 30 and 60 degrees.

Clause 9. The BAW resonator of clause 7 or 8, wherein the dual-step BO structure further includes a second transition section formed about an inner periphery of the dual-step BO structure, wherein a height of the second transition section varies from zero to the first height of the inner BO ring to form a tapered wall.

Clause 10. The BAW resonator of clause 9, wherein: a first angle, which is formed between a tapered wall of the first transition section and a horizontal plane parallel with a top surface of the piezoelectric layer, is between 30 and 60 degrees; and a second angle, which is formed between a tapered wall of the second transition section and the horizontal plane is between 30 and 60 degrees.

Clause 11. The BAW resonator of clause 10, wherein the first angle and the second angle have different angle values.

Clause 12. The BAW resonator of clause 10, wherein the first angle and the second angle have a same angle value.

Clause 13. The BAW resonator of any preceding clause, wherein the top electrode structure further includes a BO extension and a top electrode lead, wherein: the BO extension is in contact with and extends outwardly from the outer BO ring of the dual-step BO structure; and the top electrode lead is in contact with the top electrode and extends over the BO extension.

Clause 14. The BAW resonator of clause 13, wherein the BO extension is formed of a same material as the dual-step BO structure.

Clause 15. The BAW resonator of clause 14, wherein the dual-step BO structure and the BO extension are formed of silicon oxide.

Clause 16. The BAW resonator of any preceding clause, wherein: the top electrode includes a first top electrode layer, which is formed over the central region of the piezoelectric layer and extends over the dual-step BO structure, an electrode seed layer formed over the first top electrode layer, and a second top electrode layer formed over the electrode seed layer.

Clause 17. The BAW resonator of clause 16, wherein: the first top electrode layer is formed of tungsten (W), molybdenum (Mo), or platinum (Pt); the electrode seed layer is formed of Titanium Tungsten (TiW) or Titanium (Ti); and the second top electrode layer is formed of aluminum copper.

Clause 18. The BAW resonator of clause 17 further comprising a passivation layer that covers the top electrode structure and portions of the piezoelectric layer exposed through the top electrode structure, wherein the passivation layer is formed of Silicon Nitride (SiN), SiO2, or Silicon Oxynitride (SiON), with a thickness between 250 Å and 5000 Å.

Clause 19. The BAW resonator of clause 18, wherein a certain portion of at least one of the first top electrode layer, the electrode seed layer, the second top electrode layer, and the passivation layer has a thickness change, wherein the certain portion is above and confined within the inner BO ring.

Clause 20. The BAW resonator of any preceding clause, wherein a certain portion of at least one of the first top electrode layer, the electrode seed layer, the second top electrode layer, and the passivation layer has a thickness change, wherein the certain portion is above and confined within the outer BO ring.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

## Claims

1. A bulk acoustic wave (BAW) resonator comprising:
a bottom electrode;
a piezoelectric layer over the bottom electrode; and
a top electrode structure including a top electrode and a dual-step border (BO) ring structure, wherein:
the dual-step BO structure is formed over the piezoelectric layer and about a periphery of the top electrode structure, such that a central portion of the piezoelectric layer is not covered by the dual-step BO structure;
the dual-step BO structure includes an inner BO ring with a first height and an outer BO ring with a second height that is greater than the first height, such that the dual-step BO structure decreases in height toward the central portion of the piezoelectric layer; and
the top electrode is formed over the central portion of the piezoelectric layer and extends over the dual-step BO structure.

2. The BAW resonator of claim 1, wherein the dual-step BO structure is formed of a dielectric material.

3. The BAW resonator of claim 2, wherein the dual-step BO structure is formed of silicon oxide.

4. The BAW resonator of claim 1, 2 or 3, wherein the first height of the inner BO ring is 40%-60% of the second height of the outer BO ring.

5. The BAW resonator of any preceding claim, wherein the dimensions of the inner BO ring and outer BO ring comprise one or more selected from the group comprising:
the first height of the inner BO ring is between 100 nm and 500 nm, and the second height of the outer BO ring is between 200 nm and 1000 nm; and
the inner BO ring has a first width between 500 nm and 1.25 µm, and the outer BO ring has a second width between 1 µm and 2.25 µm.

6. The BAW resonator of any preceding claim, wherein the dual-step BO structure further includes a first transition section laterally between the inner BO ring and the outer BO ring, wherein a height of the first transition section varies from the first height of the inner BO ring to the second height of the outer BO ring to form a tapered wall.

7. The BAW resonator of claim 6, wherein a first angle, which is formed between a tapered wall of the first transition section and a horizontal plane parallel with a top surface of the piezoelectric layer, is between 30 and 60 degrees.

8. The BAW resonator of claim 6 or 7, wherein the dual-step BO structure further includes a second transition section formed about an inner periphery of the dual-step BO structure, wherein a height of the second transition section varies from zero to the first height of the inner BO ring to form a tapered wall.

9. The BAW resonator of claim 8, wherein:
a first angle, which is formed between a tapered wall of the first transition section and a horizontal plane parallel with a top surface of the piezoelectric layer, is between 30 and 60 degrees; and
a second angle, which is formed between a tapered wall of the second transition section and the horizontal plane is between 30 and 60 degrees.

10. The BAW resonator of any preceding claim, wherein the top electrode structure further includes a BO extension and a top electrode lead, wherein:
the BO extension is in contact with and extends outwardly from the outer BO ring of the dual-step BO structure; and
the top electrode lead is in contact with the top electrode and extends over the BO extension.

11. The BAW resonator of claim 10, wherein the BO extension is formed of a same material as the dual-step BO structure, for example wherein the material is silicon oxide.

12. The BAW resonator of any preceding claim, wherein:
the top electrode includes a first top electrode layer, which is formed over the central region of the piezoelectric layer and extends over the dual-step BO structure, an electrode seed layer formed over the first top electrode layer, and a second top electrode layer formed over the electrode seed layer.

13. The BAW resonator of claim 12, wherein:
the first top electrode layer is formed of tungsten (W), molybdenum (Mo), or platinum (Pt);
the electrode seed layer is formed of Titanium Tungsten (TiW) or Titanium (Ti); and
the second top electrode layer is formed of aluminum copper.

14. The BAW resonator of claim 13 further comprising a passivation layer that covers the top electrode structure and portions of the piezoelectric layer exposed through the top electrode structure, wherein the passivation layer is formed of Silicon Nitride (SiN), SiO2, or Silicon Oxynitride (SiON), with a thickness between 250 Å and 5000 Å, and for example wherein a certain portion of at least one of the first top electrode layer, the electrode seed layer, the second top electrode layer, and the passivation layer has a thickness change, wherein the certain portion is above and confined within the inner BO ring.

15. The BAW resonator of any preceding claim, wherein a certain portion of at least one of the first top electrode layer, the electrode seed layer, the second top electrode layer, and the passivation layer has a thickness change, wherein the certain portion is above and confined within the outer BO ring.
